# EUROPEAN PATENT APPLICATION

(11) **EP 4 791 176 A1**
(43) Date of publication of application: **12.08.2026**
(21) Application number: 26154736.8
(22) Date of filing: 28.01.2026
(51) Int. Cl.: H10W 40/30, H10W 40/25, H10W 40/00, H10W 40/40, H10W 74/10, H05K 1/181, H05K 3/325, H10W 72/00, H10W 90/10, H10W 70/60, H10W 72/30, H05K 7/20, H10W 40/73, H05K 1/02

(54) **MODULES DE PUISSANCE**

(30) Priority: 11.02.2025 US 202519051120
(71) Applicant: STMicroelectronics International N.V., 1228 Plan-les-Ouates, Geneva (CH)
(72) Inventor: YOO, Inpil, 82008 Unterhaching (DE); PAUL, Indrajit, 88677 Markdorf (DE)
(74) Representative: Casalonga

(57) **Abstract**

The present disclosure is directed to a power module that powers and controls various electronics, such an electric motor of an electric vehicle. The device includes a plurality of dies on a substrate, and a molding covering the dies and the substrate. The substrate is positioned on a heat sink. Connection pins are electrically coupled to the dies, and extend from the dies, through the molding, and into a printed circuit board. The printed circuit board is spaced from an upper surface of the molding.

## Description

### BACKGROUND

**The** present disclosure is directed to power modules and manufacturing thereof.

### DESCRIPTION OF THE RELATED ART

Many applications utilize power circuits or modules to power and control various electronics. For example, electric vehicles include power modules that power and control electronics for the vehicle's electric motor.

Such power modules have complex structures with various cooling solutions to avoid overheating. A power module, for example, includes various integrated circuits *(e.g.,* power phase inverters, rectifiers, etc.), a die interconnection structure that provide electrical connections for the integrated circuits, and source connections electrically coupled to external devices (e.g., electric motor, power sources, etc.). As the power module operates at high voltages and generate substantial heat, various cooling techniques are used to regulate the temperature of the power module.

The complex structures and interconnections of these power modules demand expensive manufacturing materials and complex manufacturing steps to embed the integrated circuits and achieve electrical isolation, and often involve multiple suppliers. Consequently, the structures and interconnections of current power modules are constraints for streamlined, simple, and effective solutions for manufacturing of power modules.

### BRIEF SUMMARY

The present disclosure is directed to a device that combines a partially embedding solution with cooling, such as immersive cooling. The device is, for example, a power module that powers and controls various electronics, such an electric motor of an electric vehicle.

The device includes a plurality of dies on a substrate with a molding covering the dies and the substrate. The substrate, along with the dies and molding, are positioned on a heat sink. Connection pins are electrically coupled to the various integrated circuits of the dies. The connection pins are press fit pins that extend from the dies, through the molding, and into a printed circuit board. When inserted into the printed circuit board, the connecting pins are electrically coupled to electrical traces on the printed circuit board. As such, the printed circuit board is electrically coupled to the dies through the connection pins. The electrical connections of the printed circuit board transfer signals between the dies and various supporting integrated circuits, such as drivers, converters, and bridges, on the printed circuit board. A space is provided between the printed circuit board and an upper surface of the molding.

### BRIEF DESCRIPTION OF THE SEVERAL VIEWS OF THE DRAWINGS

In the drawings, identical reference numbers identify similar features or elements. The size and relative positions of features in the drawings are not necessarily drawn to scale.
Figure 1 is a cross-sectional view of a device according to an embodiment disclosed herein.
Figures 2A, 2B, 2C, 2D, 2E, and 2F are subsequent manufacturing steps of the device of Figure 1 according to an embodiment disclosed herein.
Figure 3 is a system including a plurality of devices according to an embodiment disclosed herein.

### DETAILED DESCRIPTION

In the following description, certain specific details are set forth in order to provide a thorough understanding of various aspects of the disclosed subject matter. However, the disclosed subject matter may be practiced without these specific details. In some instances, well-known structures and methods of manufacturing electronic components, power modules, dies, and printed circuit boards (PCBs) have not been described in detail to avoid obscuring the descriptions of other aspects of the present disclosure.

Unless the context requires otherwise, throughout the specification and claims that follow, the word "comprise" and variations thereof, such as "comprises" and "comprising," are to be construed in an open, inclusive sense, that is, as "including, but not limited to."

Reference throughout the specification to "one embodiment" or "an embodiment" means that a particular feature, structure, or characteristic described in connection with the embodiment is included in at least one embodiment. Thus, the appearance of the phrases "in one embodiment" or "in an embodiment" in various places throughout the specification are not necessarily all referring to the same aspect. Furthermore, the particular features, structures, or characteristics may be combined in any suitable manner in one or more aspects of the present disclosure.

As discussed above, power modules for applications, particularly automotive applications, utilize power modules with complex structures and interconnections. Consequently, current power modules typically come with specialized manufacturing processes and high costs. The present disclosure provides a power module that combines a partially embedding solution with cooling, such as immersive cooling, in order to simplify the design and minimizes costs of the power module.

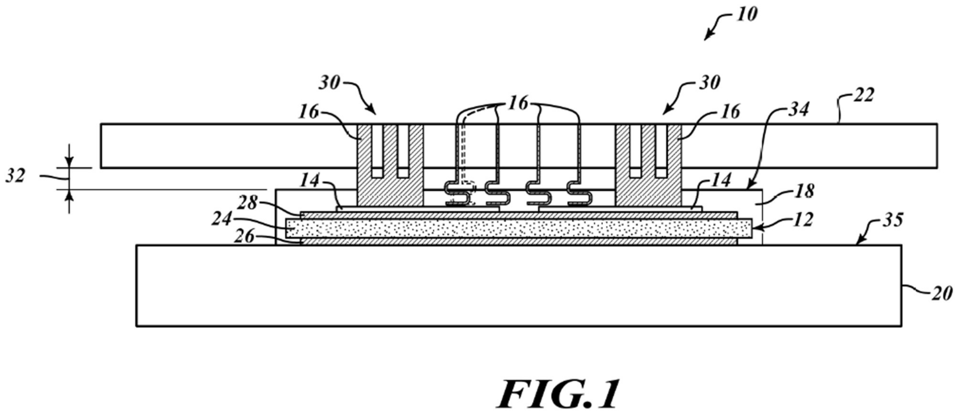

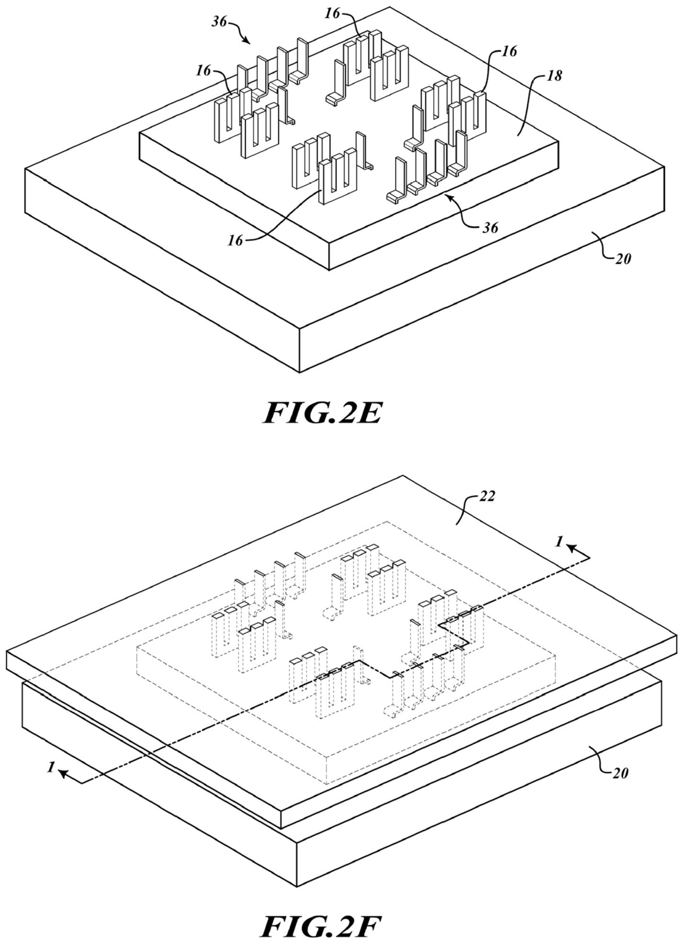

Figure 1 is a cross-sectional view of a device 10 according to an embodiment disclosed herein. The cross-section is along the line shown in Figure 2F. The device 10 is a power module or package that powers and controls various electronics for various applications, such an electric motor for an electric vehicle.

The device 10 includes a substrate 12, a plurality of dies 14, connection pins 16, molding 18, a heat sink 20, and a printed circuit board 22. The substrate 12, plurality of dies 14, connection pins 16, molding 18 together form an elementary device 1 of device 10. Said elementary device 1 is positioned between the heat sink 20 and the printed circuit board 22.

The substrate 12 is a support layer that provides support for the plurality of dies 14. The substrate 12 is a semiconductor substrate or a multilayer substrate having multiple sub-layers. Other types of substrates are also possible. In one embodiment, as shown in Figure 1, the substrate 12 includes an insulating layer 24; a first conductive layer 26 on a first, bottom side of the insulating layer 24; and a second conductive layer 28 on a second, top side of the insulating layer 24. The first and second sides of the insulating layer 24 face in opposite directions. The insulating layer 24 is made of a suitable insulating material, such as ceramic. The first and second conductive layers 26, 28 are made of a suitable conductive metal, such as copper. The substrate 12 provides electrical insulation for the plurality of dies 14. Further, the first and second conductive layers 26, 28 increases thermal conductivity of the substrate 12 and act as heat spreaders.

The plurality of dies 14 are on the substrate 12, more specifically on the second conductive layer 28. The dies 14 are semiconductor dies that include various integrated circuits. For example, the dies 14 include power phase inverters, rectifiers, converters, charging circuits, and other applicable semiconductor components.

The connection pins 16 are on the plurality of dies 14. The connection pins 16 are conductive pins electrically coupled to the various integrated circuits included in the dies 14. The connection pins 16 are press fit pins that are pressed and inserted into the printed circuit board 22. Each of the connection pins 16 have a first end electrically connected to one of the dies 14 and a second, opposite end inserted into and electrically connected to the printed circuit board 22. When inserted, the connection pins 16 provide an electrical connection between the integrated circuits of the dies 14 and electrical connections of the printed circuit board 22. The connection pins 16 are made of a suitable conductive metal, such as copper.

The molding 18 is formed on the substrate 12, the plurality of dies 14, the connection pins 16, and the heat sink 20. The molding 18 encapsulates and provides a protection layer for the substrate 12 and the plurality of dies 14. The molding 18 extends along the second conductive layer 28 on the second, top side of the insulating layer 24 and along side surfaces of the substrate 12. The connection pins 16 extend from the dies 14, through portions of the molding 18 on the second conductive layer 28, and to the printed circuit board 22. The molding 18 is made of a suitable insulating material, such as a molding compound, an encapsulant, or an epoxy.

The heat sink 20 supports the substrate 12, the plurality of dies 14, the connection pins 16, the molding 18, and the printed circuit board 22. The substrate 12, more specifically the first conductive layer 26, is positioned on the heat sink 20. The substrate 12 may be attached to the heat sink 20 without any isolation material, such as AMB SiN. The heat sink 20 absorbs and transfers heat away from the plurality of dies 14. Stated differently, heat generated by the plurality of dies 14 is transferred from the dies 14, through the substrate 12, and to the heat sink 20. In one embodiment, as shown in Figure 1, the dimensions (*e.g.,* length, width, and height) of the heat sink 20 are larger than the dimensions of the substrate 12 in order to maximize contact between the heat sink 20 with the substrate 12 and the surrounding environment (*e.g.,* air, water, or another immersive coolant). The heat sink 20 is made of a suitable conductive metal, such as aluminum or copper. In one embodiment, the substrate 12 is attached to the heat sink 20 with conductive material, such as sinter. In one embodiment, a conductive film, such as graphite film, is formed on an upper surface of the heat sink 20 (*e.g.,* between the heat sink 20 and the substrate 12) to further increase heat spreading.

Other types of heat dissipation techniques may be used besides the heat sink 20. In one embodiment, the heat sink 20 is replaced by a vapor chamber filled with a coolant, such as air or liquid. The substrate 12 is positioned in the vapor chamber.

The printed circuit board 22 is coupled to the connection pins 16. Namely, the connection pins 16 are inserted into trenches 30 extending into the printed circuit board 22 and having sidewalls coated with a conductive material. When inserted into the trenches 30, the connecting pins 16 are electrically coupled to the electrical connections or traces on the printed circuit board 22. As a result, the printed circuit board 22 is electrically coupled to the plurality of dies 14 through the connection pins 16. In one embodiment, the electrically connections of the printed circuit board 22 are attached to the connection pins 16 with conductive material, such as solder or sinter.

The printed circuit board 22 includes electrical connections to transfer electrical signals (*e.g.,* power signals) between the dies 14 and integrated circuits on or electrically coupled to the printed circuit board 22 and that support the dies 14 (*e.g.,* drivers, converters, and bridges on or connected to the printed circuit board 22). In one embodiment, the printed circuit board 22 does not include any of the dies 14. Rather, the printed circuit board 22 is used simply to route signals to the dies 14 from the integrated circuits that support the dies 14. This allows for short interconnections, low parasitic, low switching losses, low stray inductance, and high switching speeds. Further, the separation of the dies 14 from the printed circuit board 22 simplifies the design complexity of the device 10 and minimizes reliability concerns, while also allowing for a high level of freedom in design to route various signals.

As shown in Figure 1, the connection pins 16 are partially inserted into the printed circuit board 22 such that there is a space 32 between the printed circuit board 22 and an upper surface 34 of the molding 18. The space 32 allows for various cooling techniques to be used for the dies 14. For example, a general, non-immersive cooling may be used in conjunction with the substrate 12 and the heat sink 20 discussed above. As another example, a non-isolated immersive cooling of the dies 14 may be used. In this case, an immersive coolant, such as air or liquid, surround the dies 14 and the heat sink 20 and fill the space 32. The immersive coolant should have dielectric electrical properties. Further, the substate 12 does not have to include the insulating layer 24 (*e.g.,* the substrate 12 may instead include one or more conductive layers, such as copper). The printed circuit board 22 is also spaced from an upper surface 35 of the heat sink 20 that is left uncovered by the substrate 12 and the molding 18. As such, the heat sink 20 is also cooled by the immersive coolant. The space between the printed circuit board 22 and the upper surface 35 of the heat sink 20 is larger than the space 32.

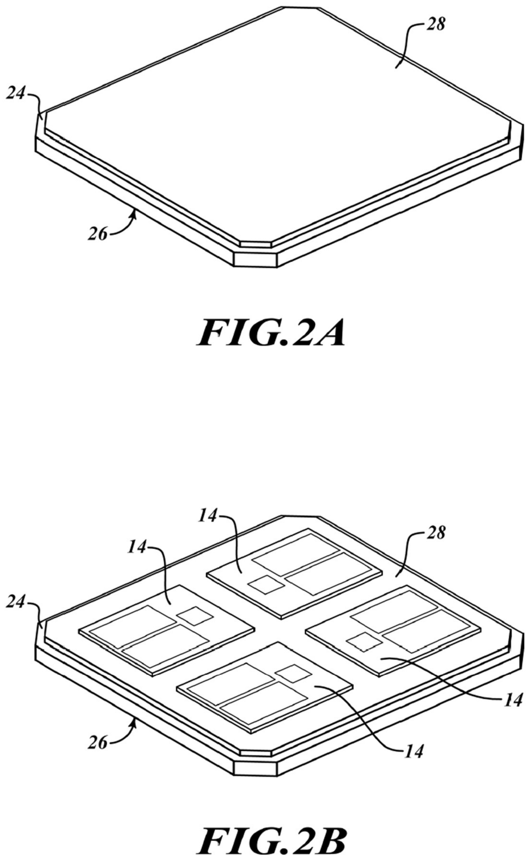

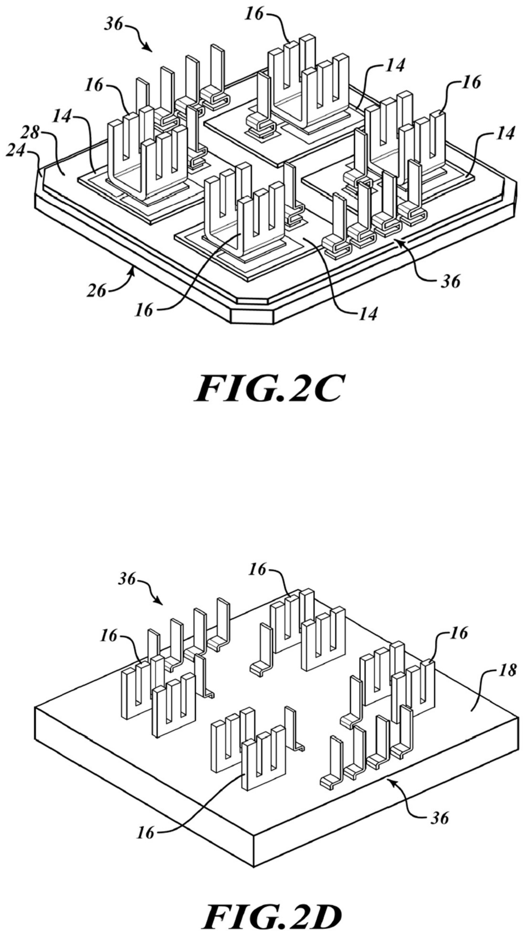

Figures 2A, 2B, 2C, 2D, 2E, and 2F are subsequent manufacturing steps of the device 10 of Figure 1 according to an embodiment disclosed herein.

In Figure 2A, the substrate 12 is prepared. As discussed above, in one embodiment, as shown in Figures 1 and 2A, the substrate 12 includes the insulating layer 24; the first conductive layer 26 on a first, bottom side of the insulating layer 24; and the second conductive layer 28 on a second, top side of the insulating layer 24.

In Figure 2B, the plurality of dies 14 are positioned on and attached to the substrate 12, more specifically on the second conductive layer 28. As discussed above, the dies 14 are semiconductor dies that include various integrated circuits, such as power phase inverters, rectifiers, converters, charging circuits, and other applicable semiconductor components.

In Figure 2C, the connection pins 16 are electrically coupled to the various integrated circuits included in the dies 14 by, for example, solder or sinter. As discussed above, the connection pins 16 are press fit pins that are pressed and inserted into the printed circuit board 22. When inserted, the connection pins 16 provide an electrical connection between the integrated circuits of the dies 14 and electrical connections of the printed circuit board 22.

In one embodiment, the connection pins 16 include coupling pins 36. The coupling pins 36 are physically coupled to the substrate 12, but are not electrically coupled to the integrated circuits of the dies 14. The coupling pins 36 are press fit pins that are pressed and inserted into the printed circuit board 22 in order to securely attach the substrate 12 to the printed circuit board 22. As shown in Figure 2C, the couplings pins 36 include a first set of coupling pins and a second set of coupling pins positioned on opposite sides of the substrate 12.

In Figure 2D, the molding 18 is formed on the substrate 12, the plurality of dies 14, and the connection pins 16. The molding 18 extends along the second conductive layer 28 on the second, top side of the insulating layer 24 and along side surfaces of the substrate 12. The molding encapsulates the substrate 12 and the plurality of dies 14, as well as the first ends of the connection pins 16 that are electrically connected to the dies 14. The connection pins 16 extend from the dies 14, through portions of the molding 18 on the second conductive layer 28, and out of the molding 18. The second ends of the connection pins 16, which are inserted into and electrically connected to the printed circuit board 22, extend out of and are left exposed from the molding 18.

In Figure 2E, the substrate 12, the plurality of dies 14, the connection pins 16, and the molding 18 are positioned on and attached to the heat sink 20 by, for example, solder or sinter. More specifically, the first conductive layer 26 of the substrate 12 is attached to the heat sink 20. As discussed above, heat generated by the plurality of dies 14 is transferred from the dies 14, through the substrate 12, and to the heat sink 20.

In Figure 2F, the device 10 as shown in Figure 1 is obtained by coupling the printed circuit board 22 to the connection pins 16. As discussed above, the printed circuit board 22 is coupled to the connection pins 16 by inserting the connection pins 16 into the trenches 30 extending into the printed circuit board 22. As a result, the connecting pins 16 are electrically coupled to the electrical connections or traces on the printed circuit board 22, and the printed circuit board 22 is electrically coupled to the plurality of dies 14 through the connection pins 16.

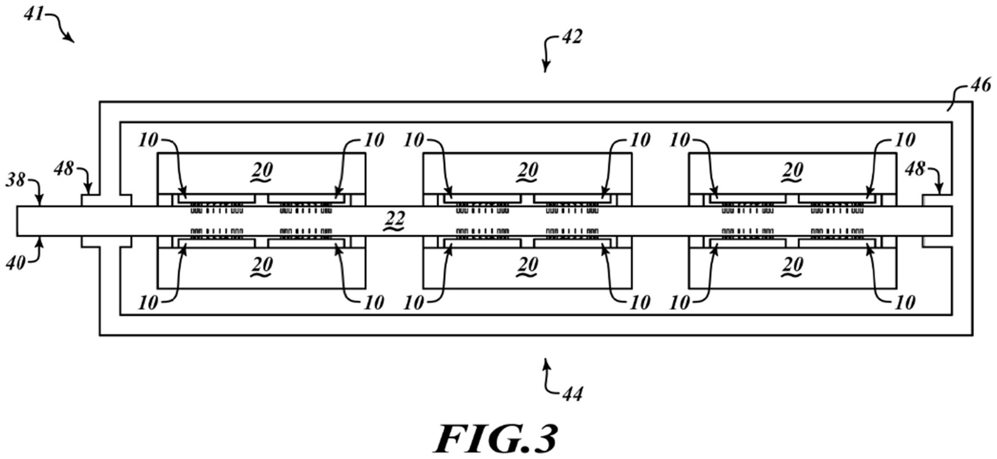

Figure 3 is a system 41 including a plurality of the devices 10 according to an embodiment disclosed herein. Each of the devices 10 are as discussed with respect to Figure 1. However, the plurality of devices 10 share the same printed circuit board 22. The system 41 includes a plurality of elementary devices 1 positioned between the printed circuit board 22 and the plurality of heat sinks 20.

The printed circuit board 22 has a first side 38 and a second side 40 opposite to the first side 38. Each of the first side 38 and the second side 40 include electrical connections or traces on the printed circuit board 22.

A first set 42 of the devices 10 are positioned on the first side 38, and a second set 44 of the devices 10 are positioned on the second side 40. Although three devices 10 are shown on each side of the printed circuit board 22, any number of devices may be positioned on each side of the printed circuit board 22. As discussed above, when the connection pins 16 of a device 10 are inserted into the printed circuit board 22, the connection pins 16 provide an electrical connection between the dies 14 of the device 10 and the electrical connections of the printed circuit board 22.

The printed circuit board 22 is sandwiched between the first set 42 of the devices 10 and the second set 44 of the devices 10. Stated differently, the first set 42 of the devices 10 are spaced from the second set 44 of the devices 10 by the printed circuit board 22. In one embodiment, as shown in Figure 3, each device of the first set 42 of the devices 10 is overlapped or aligned with a respective device of the second set 44 of the devices 10. In this embodiment, the connection pins 16 of the device of the first set 42 are spaced from the connection pins 16 of the respective device of the second set 44 by a portion of the printed circuit board 22 in order to avoid cross connections.

Each of the devices 10 are coupled to a heat sink 20 as discussed above. In one embodiment, each of the devices 10 are coupled to a respective heat sink 20. In one embodiment, two or more devices 10 share the same heat sink 20. For example, in Figure 3, two devices 10 are positioned on the same heat sink 20.

The devices 10 are enclosed by a housing 46. The housing 46 includes attachment portions 48 positioned on opposite sides of the housing 46. The printed circuit board 22 is coupled to the housing by the attachment portions 48. The housing 46 protects the devices 10 and provides an enclosed cavity for the devices 10. In one embodiment, an immersive coolant, such as air or liquid, is provided in the cavity of the housing 46 that surrounds the devices 10 and fills the spaces 32 of the device 10.

The various embodiments disclosed herein provide a device that combines a partially embedding solution with cooling, such as immersive cooling. The device may be fabricated with a relatively simple process and without high cost components, such as isolation material.

A device is summarized as including a first heat sink; a first substrate on the first heat sink; a first plurality of dies on the first substrate; a first molding on the first plurality of dies and the first substrate; a first plurality of connection pins electrically coupled to the first plurality of dies; and a printed circuit board electrically coupled to the first plurality of connection pins, the first plurality of connection pins extending from the first plurality of dies, through a surface of the first molding, and to the printed circuit board, the printed circuit board being spaced from the surface of the first molding.

The first substrate may include a first conductive layer; an insulating layer on the first conductive layer; and a second conductive layer on the insulating layer, the first plurality of dies being on the second conductive layer.

The printed circuit board may include an integrated circuit and electrical connections electrically coupled to the integrated circuit and the first plurality of connection pins.

The printed circuit board may include a plurality of trenches, and the first plurality of connection pins are inserted into the plurality of trenches.

The device may further include an immersive coolant extending between a space between the printed circuit board and the surface of the first molding.

The first substrate may be attached to the heat sink by solder or sinter.

The first plurality of connection pins may be attached to the first plurality of dies by solder or sinter.

The device may further include a second substrate; a second plurality of dies on the second substrate; a second molding on the second plurality of dies and the second substrate; and a second plurality of connection pins electrically coupled to the second plurality of dies, the printed circuit board electrically coupled to the second plurality of connection pins, the second plurality of connection pins extending from the second plurality of dies, through a surface of the second molding, and to the printed circuit board, the printed circuit board being spaced from the surface of the second molding.

The second substrate may be on the first heat sink.

The device further may include a second heat sink, the second substrate being on the second heat sink.

The first substrate and the second substrate may be positioned on opposite sides of the printed circuit board.

**The** device may further include a housing, the first heat sink, the first substrate, the first plurality of dies the first molding, the first plurality of connection pins, and the printed circuit board being in the housing.

A method is summarized as including positioning a plurality of dies on a substrate; electrically coupling a plurality of connection pins to the plurality of dies; forming a molding on the plurality of dies and the substrate; positioning the substrate on a heat sink; and electrically coupling a printed circuit board to the plurality of connection pins by inserting the plurality of connection pins into the printed circuit board, the plurality of connection pins extending from the plurality of dies, through a surface of the molding, and to the printed circuit board, the printed circuit board being spaced from the surface of the molding.

The substrate may include a first conductive layer; an insulating layer on the first conductive layer; and a second conductive layer on the insulating layer, the plurality of dies being on the second conductive layer.

The method may further include providing an immersive coolant between a space between the printed circuit board and the surface of the molding.

Positioning the substrate on the heat sink may include attaching the substrate to the heat sink by solder or sinter.

Electrically coupling the plurality of connection pins to the plurality of dies may include attaching the plurality of connection pins to the plurality of dies by solder or sinter.

A system is summarized a including a printed circuit board; a plurality of heat sinks; and a plurality of elementary devices positioned between the printed circuit board and the plurality of heat sinks, each of the plurality of elementary devices including: a substrate; a plurality of dies on the substrate; a molding on the plurality of dies and the substrate; and a plurality of connection pins electrically coupled between the plurality of dies and the printed circuit board, the plurality of connection pins extending from the plurality of dies, through a surface of the molding, and to the printed circuit board, the printed circuit board being spaced from the surface of the molding.

A first elementary device of the plurality of elementary devices may be on a first heat sink of the plurality of heat sinks, a second elementary device of the plurality of elementary devices may be on a second heat sink of the plurality of heat sinks, and the first elementary device may be spaced from the second elementary device by the printed circuit board.

A first elementary device and a second elementary device of the plurality of elementary devices may be on a first heat sink of the plurality of heat sinks, and the first heat sink may be spaced from the printed circuit board by the first elementary device and the second elementary device.

**The** various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device (10), comprising:
∘ a first heat sink (20);
∘ a first substrate (12) on the first heat sink (20);
∘ a first plurality of dies (14) on the first substrate (12);
∘ a first molding (18) on the first plurality of dies (14) and the first substrate (12);
∘ a first plurality of connection pins (16) electrically coupled to the first plurality of dies (14); and
∘ a printed circuit board (22) electrically coupled to the first plurality of connection pins (16),
• the first plurality of connection pins (16) extending from the first plurality of dies (14), through a surface of the first molding (18), and to the printed circuit board (22),
• the printed circuit board (22) being spaced from the surface of the first molding (18).

2. The device of claim 1, wherein the first substrate (12) includes:
∘ a first conductive layer (26);
∘ an insulating layer (24) on the first conductive layer; and
∘ a second conductive layer (28) on the insulating layer, the first plurality of dies (14) being on the second conductive layer.

3. The device of any one of claim 1 or 2, wherein the printed circuit board (22) includes an integrated circuit and electrical connections electrically coupled to the integrated circuit and the first plurality of connection pins.

4. The device of any one of claims 1 to 3, wherein the printed circuit board (22) includes a plurality of trenches (30), and the first plurality of connection pins are inserted into the plurality of trenches.

5. The device of any one of claims 1 to 4, further comprising:
∘ an immersive coolant extending between a space between the printed circuit board (22) and the surface of the first molding (18).

6. The device of any one of claims 1 to 5, wherein the first substrate (12) is attached to the heat sink (20) by solder or sinter.

7. The device of any one of claims 1 to 6, wherein the first plurality of connection pins (16) are attached to the first plurality of dies (14) by solder or sinter.

8. The device of any one of claims 1 to 7, further comprising:
∘ a second substrate;
∘ a second plurality of dies on the second substrate;
∘ a second molding on the second plurality of dies and the second substrate; and
∘ a second plurality of connection pins electrically coupled to the second plurality of dies,
• the printed circuit board electrically coupled to the second plurality of connection pins,
• the second plurality of connection pins extending from the second plurality of dies, through a surface of the second molding, and to the printed circuit board, and
• the printed circuit board being spaced from the surface of the second molding.

9. The device of claim 8, wherein the second substrate is on the first heat sink.

10. The device of claim 8 or 9, further comprising:
∘ a second heat sink, the second substrate being on the second heat sink.

11. The device of any one of claims 8 to 10, wherein the first substrate and the second substrate are positioned on opposite sides of the printed circuit board.

12. The device of any one of claims 8 to 11, further comprising:
∘ a housing, the first heat sink, the first substrate, the first plurality of dies the first molding, the first plurality of connection pins, and the printed circuit board being in the housing.

13. A method, comprising:
∘ positioning a plurality of dies (14) on a substrate (12);
∘ electrically coupling a plurality of connection pins (16) to the plurality of dies (14);
∘ forming a molding (18) on the plurality of dies (14) and the substrate (12);
∘ positioning the substrate (12) on a heat sink (20); and
∘ electrically coupling a printed circuit board (22) to the plurality of connection pins (16) by inserting the plurality of connection pins into the printed circuit board,
• the plurality of connection pins (16) extending from the plurality of dies (14), through a surface of the molding (18), and to the printed circuit board (22),
• the printed circuit board (22) being spaced from the surface of the molding (18).

14. The method of claim 13, further comprising:
∘ providing an immersive coolant between a space between the printed circuit board and the surface of the molding.

15. The method of claim 13 or 14, wherein positioning the substrate on the heat sink includes attaching the substrate to the heat sink by solder or sinter.

16. The method of any one of claims 13 to 15, wherein electrically coupling the plurality of connection pins to the plurality of dies includes attaching the plurality of connection pins to the plurality of dies by solder or sinter.

17. A system (41), comprising:
∘ a printed circuit board (22);
∘ a plurality of heat sinks (20); and
∘ a plurality of elementary devices (1) positioned between the printed circuit board (22) and the plurality of heat sinks (20), each of the plurality of elementary devices (1) including:
• a substrate (12);
• a plurality of dies (14) on the substrate (12);
• a molding (18) on the plurality of dies (14) and the substrate (12); and
• a plurality of connection pins (16) electrically coupled between the plurality of dies (14) and the printed circuit board (22),
- the plurality of connection pins (16) extending from the plurality of dies (14), through a surface of the molding (18), and to the printed circuit board (22),
- the printed circuit board (22) being spaced from the surface of the molding (18).

18. The system of claim 17, wherein
∘ a first elementary device of the plurality of elementary devices is on a first heat sink of the plurality of heat sinks,
∘ a second elementary device of the plurality of elementary devices is on a second heat sink of the plurality of heat sinks, and
∘ the first elementary device is spaced from the second elementary device by the printed circuit board.

19. The system of claim 17 or 18, wherein
∘ a first elementary device and a second elementary device of the plurality of elementary devices are on a first heat sink of the plurality of heat sinks, and
∘ the first heat sink is spaced from the printed circuit board by the first elementary device and the second elementary device.
